# EUROPEAN PATENT SPECIFICATION

(11) **EP 2 869 315 B1**
(45) Date of publication and mention of the grant of the patent: **06.05.2020**
(21) Application number: 14275082.7
(22) Date of filing: 14.04.2014
(51) Int. Cl.: H01F 38/14

(54) **Wireless power relay apparatus and case including the same**
Drahtlose Leistungsrelaisvorrichtung und Gehäuse damit
Appareil de relais de puissance sans fil et étui comprenant celui-ci

(30) Priority: 31.10.2013 KR 20130131338
(43) Date of publication of application: 06.05.2015
(73) Proprietor: WITS Co., Ltd., Cheoin-gu, Yongin-si, Gyeonggi-do (KR)
(72) Inventor: Kang, Chang Soo, Gyeonggi-Do (KR); Oh, Soon Tack, Gyeonggi-Do (KR); Lee, Sung Uk, Gyeonggi-Do (KR); Lim, Hyun Keun, Gyeonggi-Do (KR); Kim, Si Hyung, Gyeonggi-Do (KR); Sung, Jae Suk, Gyeonggi-Do (KR); Park, Chul Gyun, Gyeonggi-Do (KR); Chang, Ki Won, Gyeonggi-Do (KR)
(74) Representative: RGTH

(56) References cited:
- EP-A2- 0 829 940
- WO-A1-2013/031988
- WO-A2-2013/002516
- JP-A- 2011 151 946
- JP-A- 2011 160 634
- US-A1- 2012 075 148

## Description

### CROSS-REFERENCE TO RELATED APPLICATION

This application claims the benefit of Korean Patent Application No. 10-2013-0131338 filed on October 31, 2013, with the Korean Intellectual Property Office.

### BACKGROUND

The present disclosure relates to a wireless power relay apparatus and a case including the same, and more particularly, to a wireless power relay apparatus capable of improving charging efficiency by relaying wireless power within a wireless charging system, and a case including the same.

In wireless power transmission technology or in wireless energy transfer technology for wirelessly transferring electrical energy to an apparatus, electric motors and transformers using the principle of electromagnetic induction began to be used in the late 1800's. Since then, various methods of radiating electromagnetic waves such as radio waves or a laser beam to transmit electric energy have been attempted.

Recently, a method of electrically coupling portable electronic apparatuses such as mobile phones, laptop computers, personal digital assistants, and the like, to a charger in a wireless scheme (not-contact scheme) to charge the portable electronic apparatuses with energy from the charger has been developed.

In a wireless charging method, a primary circuit operated at a high frequency is configured in the charger, and a secondary circuit is configured on a storage battery side, that is, in a portable electronic apparatus or a storage battery, such that current, that is, energy, of the charger is provided to the storage battery of the portable electronic apparatus by induction coupling.

The wireless charging method using induction coupling has been already used in some applications (for example, in electric toothbrushes, electric shavers, and the like).

In such a wireless charging method, charging efficiency is significantly changed depending on a distance between the charger and the storage battery of the mobile phone, or the like, or a position in which the storage battery is disposed, or the like. That is, in the case in which a user does not dispose the mobile phone in an optimal position on the charger, a charging time may be increased.

### [Related Art Document]

(Patent Document 1) Korean Patent Laid-Open Publication No. 2013-0035873
Patent Document 2) WO 2013/031988A1 discloses a power relay sending power from a magnetic-resonance power transmitter to an electromagnetic-induction electronic device. The power relay comprises a power transmitter having a primary-side coil connected to an AC power supply and a primary-side resonance coil that receives power from the primary-side coil via electromagnetic induction. Alternatively the power relay may comprise a cover part attached to an electronic device containing a secondary-side coil, and a secondary-side resonance coil on the cover part that uses electromagnetic induction to send the secondary-side coil power received from the primary-side resonance coil via magnetic resonance.

### SUMMARY

An aspect of the present disclosure provides a wireless power relay apparatus case including a wireless power relay apparatus capable of improving charging efficiency.

According to an aspect of the invention, there is provided a wireless power relay apparatus coupling case comprising: a case of an electronic apparatus; and a wireless power relay apparatus coupled to the case, and disposed between the electronic apparatus and a wireless charging apparatus to transfer received power to the electronic apparatus at the time of performing charging. The wireless power relay apparatus includes: a substrate; a coil formed on the substrate; and an impedance matching circuit electrically connected to the coil.

The coil may be formed on one surface or both surfaces of the substrate.

The circuit unit may be disposed on one surface of the substrate, and the coil may penetrate though the substrate, such that both ends thereof are electrically connected to the impedance matching circuit.

The impedance matching circuit includes: an impedance matching unit having various impedance values present through capacitors and resistors; a controlling unit selecting an appropriate impedance value from the impedance matching unit depending on a state of wireless power received by the coil; a rectifying unit rectifying the wireless power received by the coil and supplying the rectified power to the controlling unit; a detecting unit sensing a current rectified by the rectifying unit to detect a state of a wireless power transmission signal and transmit the detected state of the wireless power transmission signal to the controlling unit; and a switching unit selecting an impedance value of the impedance matching unit depending on a control of the controlling unit.

The case includes: a body case coupled to the electronic apparatus; and a cover covering a front surface of the electronic apparatus.

The wireless power relay apparatus is embedded in the case and attached to one surface of the cover.

The cover is folded toward a rear surface of the electronic apparatus at the time of performing charging.

In other arrangements not forming part of the invention, the wireless power relay apparatus may be attached to one surface of the cover.

In further arrangements not forming part of the invention, the wireless power relay apparatus may be attached to a bottom surface of the body case.

The electronic apparatus may include a portable terminal.

### BRIEF DESCRIPTION OF DRAWINGS

The above and other aspects, features and other advantages of the present disclosure will be more clearly understood from the following detailed description taken in conjunction with the accompanying drawings, in which:
FIG. 1 is a view schematically showing an equivalent circuit of a wireless power transmitting system according to an exemplary embodiment of the present disclosure;
FIG. 2 is a perspective view schematically showing the wireless power transmitting system according to an exemplary embodiment of the present disclosure;
FIG. 3 is a perspective view schematically showing a wireless power relay apparatus according to an exemplary embodiment of the present disclosure;
FIG. 4 is a perspective view schematically showing an example in which the wireless power relay apparatus according to an exemplary embodiment of the present disclosure is used;
FIG. 5 is a perspective view schematically showing a wireless power relay apparatus according to another exemplary embodiment of the present disclosure;
FIG. 6 is a functional block diagram of the wireless power relay apparatus of FIG. 5; and
FIGS. 7 and 8 are views schematically showing a case and a portable terminal according to an exemplary embodiment of the present disclosure.

### DETAILED DESCRIPTION

Hereinafter, embodiments of the present disclosure will be described in detail with reference to the accompanying drawings. The disclosure may, however, be embodied in many different forms and should not be construed as being limited to the embodiments set forth herein. Rather, these embodiments are provided so that this disclosure will be thorough and complete, and will fully convey the scope of the disclosure to those skilled in the art. In the drawings, the shapes and dimensions of elements may be exaggerated for clarity, and the same reference numerals will be used throughout to designate the same or like elements.

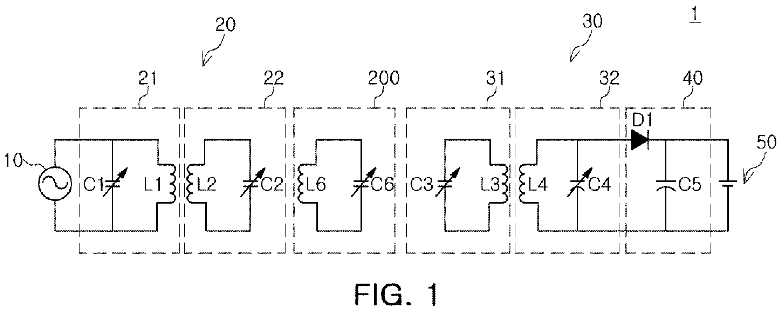

FIG. 1 is a view schematically showing an equivalent circuit of a wireless power transmitting system according to an exemplary embodiment of the present disclosure.

Referring to FIG. 1, power generated by a power source 10 may be transferred to a transmitting unit 20 of a wireless power transmitting apparatus and be then transferred to a receiving unit 30 of a wireless power receiving apparatus resonated with the transmitting unit 20 by a magnetic resonance phenomenon. The power transferred to the receiving unit 30 may be transferred to a load 50 through a rectifying circuit 40. The load 50 may be a storage battery or any apparatus requiring the power.

In more detail, the power source 10 may be an alternating current (AC) power source providing AC power having a predetermined frequency.

The transmitting unit 20 may include a transmitting coil 21 and a resonant coil 22 for transmission. The transmitting coil 21 may be connected to the power source 10 and have AC current flowing therein. When the AC current flows in the transmitting coil 21, the AC current may also flow in the resonant coil 22 for transmission physically spaced apart from the resonant coil 22 by electromagnetic induction. The power transferred to the resonant coil 22 for transmission may be transferred to the receiving unit 30 forming a resonant circuit with the transmitting unit 20 by magnetic resonance.

The power transmission by the magnetic resonance, which is a phenomenon that power is transferred between two LC circuits having impedances matched to each other, may transfer power up to a distance more distant as compared with the power transmission by the electromagnetic induction at a high efficiency.

The receiving unit 30 may include a resonant coil 31 for reception and a receiving coil 32. The power transmitted by the resonant coil 22 for transmission may be received by the resonant coil 31 for reception, such that the AC power flows in the resonant coil 31 for reception. The power transferred to the resonant coil 31 for reception may be transferred to the receiving coil 32 by electromagnetic induction. The power transferred to the receiving coil 32 may be transferred to the load 50 through the rectifying circuit 40.

Meanwhile, the transmitting coil 21 may include an inductor L1 and a capacitor C1, which configures a circuit having appropriate inductance and capacitance values. The capacitor C1 may be a variable capacitor, and impedance matching may be performed by adjusting the variable capacitor. In addition, it may also be applied to the resonant coil 22 for transmission, the resonant coil 31 for reception, the receiving coil, and an equivalent circuit of a wireless power relay apparatus 200 to be described below.

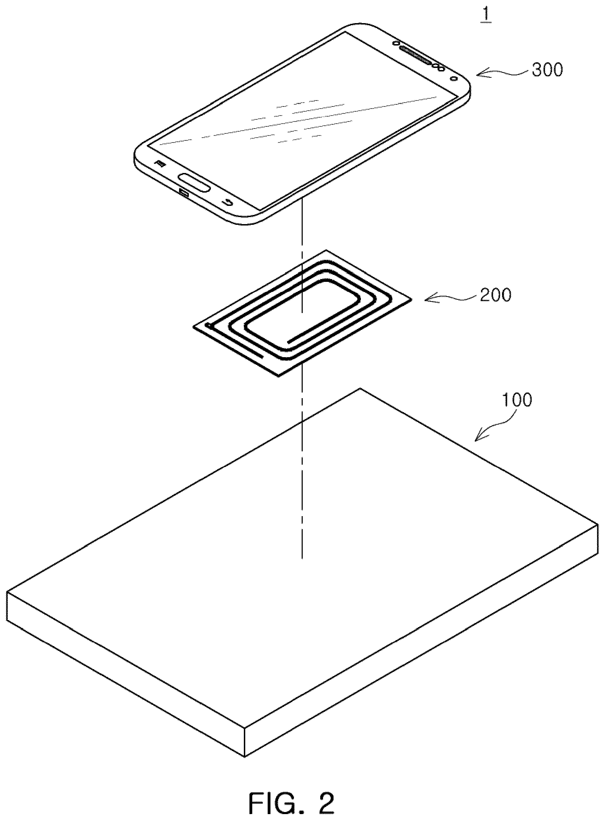

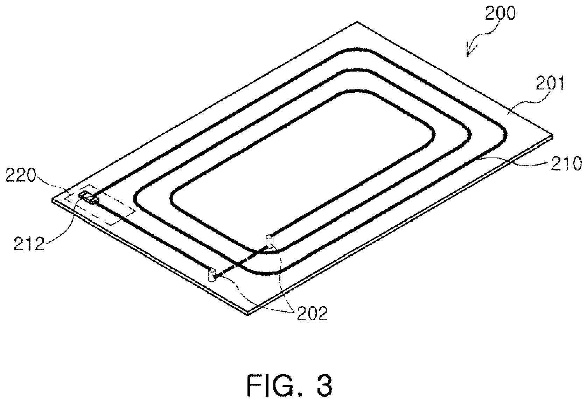

FIG. 2 is a perspective view schematically showing the wireless power transmitting system according to an exemplary embodiment of the present disclosure; and FIG. 3 is a perspective view schematically showing a wireless power relay apparatus according to an exemplary embodiment of the present disclosure.

Referring to FIGS. 2 and 3, the wireless power transmitting system 1 according to the present exemplary embodiment includes a wireless charging apparatus 100, which is the wireless power transmitting apparatus, a portable terminal 300, which is the wireless power receiving apparatus, and a wireless power relay apparatus 200 relaying wireless power.

The wireless charging apparatus 100 may include the transmitting coil 21 and the resonant coil 22 for transmission, as shown in FIG. 1. The transmitting coil 21 may be connected to the AC power source 10 and have the AC current flowing therein. When the AC current flows in the transmitting coil 21, the AC current may also flow in the resonant coil 22 for transmission physically spaced apart from the resonant coil 22 by the electromagnetic induction. The power transferred to the resonant coil 22 for transmission may be transferred to the wireless power relay apparatus 200 by magnetic resonance.

That is, the wireless charging apparatus 100 may receive the power from the AC power source connected to the outside and may transfer the power transferred to the resonant coil 22 for transmission to the wireless power relay apparatus 200 in a non-radiating scheme using the magnetic resonance.

In this scheme, the wireless charging apparatus 100 may transfer the power to the wireless power relay apparatus 200 and may also transfer the power to the portable terminal 300.

The portable terminal 300, which is the wireless power receiving apparatus, may be seated on an upper surface of the wireless charging apparatus 100.

The portable terminal 300 may include the resonant coil 31 for reception and the receiving coil 32, as shown in FIG. 1. The resonant coil 31 for reception may receive the power transmitted by the resonant coil 22 for transmission, and the power transferred to the resonant coil 31 for reception may be transferred to the receiving coil 32 by the electromagnetic induction. The power transferred to the receiving coil 32 may be rectified by the rectifying circuit 40 and may then be stored in a battery of the portable terminal 300 or be used as power driving the portable terminal 300.

The wireless power relay apparatus 200 may transmit the power received from the wireless charging apparatus 100 to the portable terminal 300. This power transmitting process may be the same as the power transfer process between the wireless charging apparatus 100 and the wireless power relay apparatus 200.

Therefore, the wireless power relay apparatus 200 may serve as a relay transferring the power to the wireless power receiving apparatus simultaneously with receiving the power from the wireless power transmitting apparatus.

The wireless power relay apparatus 200 is attached to a case of the portable terminal 300. In other arrangements not forming part of the invention the wireless power relay apparatus may be disposed in the vicinity of the portable terminal 300 or be interposed between the portable terminal 300 and the wireless charging apparatus 100.

The wireless power relay apparatus 200 may include a substrate 201 having an insulating property, coils 210 mounted on or embedded in one surface of the substrate 201 and configured to magnetically resonate with the wireless charging apparatus 100, and a circuit unit 220. Here, the circuit unit 220 may include at least one electronic element 212.

The wireless power relay apparatus 200 according to the present exemplary embodiment may have a general appearance formed in a shape of a card (for example, credit card, or the like) that may be easily carried.

As the substrate 201, which is an insulating substrate, for example, a printed circuit board (PCB), a ceramic substrate, a pre-molded substrate, a direct bonded copper (DBC) substrate, or an insulated metal substrate (IMS) may be used.

Particularly, as the substrate 201 according to the present exemplary embodiment, a flexible PCB having a thin thickness and having wiring patterns formed thereon, such as a film, a printed circuit board, or the like, may be used.

The coil 210 may be formed in a shape of a wiring pattern on at least one surface of the substrate 201. The coil 210 according to the present exemplary embodiment may be formed in a vortex shape on both surfaces or any one surface of the substrate 201 and may have both ends connected to the circuit unit 220, that is, the electronic element 212.

The coil 210 according to the present exemplary embodiment may penetrate though the substrate 201, such that both ends thereof may be electrically connected to the circuit unit 220. In more detail, most of the wiring patterns may be formed on one surface of the substrate, and some of the wiring patterns may be formed on the other surface of the substrate 201. To this end, at least one conductive via 202 may be formed in the substrate 201 according to the present exemplary embodiment.

A portion of the coil 210 according to the present exemplary embodiment may be formed on the other surface of the substrate 201 in order to lead one end of the coil 210 disposed at the center to the outside of the coil 210. In this case, the coil 210 may be move to the other surface of the substrate 201 through the conductive via 202, be extended to the outside of the coils 210, and be then moved to one surface of the substrate 201 through the conductive via 202.

However, the coil 210 according to the present exemplary embodiment is not limited to the above-mentioned configuration, but may be changed in various shapes. For example, the coils 210 having the same shape may be formed on both surfaces of the substrate 201, and both ends of the respective coils 210 may be electrically connected to each other to generally configure a parallel circuit. Alternatively, one ends of the coils 210 disposed at the center may be connected to each other to generally configure a serial circuit.

Meanwhile, although the case in which the coil 210 has a generally rectangular vortex shape has been described as an example in the present exemplary embodiment, the present disclosure is not limited thereto, but may be variously applied. For example, the coil 210 may have a circular vortex shape, a polygonal vortex shape, or the like.

In addition, the coil 210 may include an insulation protecting layer (for example, a resin insulating layer (not shown)) formed thereon in order to protect the coil 210 from the outside, if necessary.

Meanwhile, the coil 210 according to the present exemplary embodiment is not limited to the above-mentioned configuration, but may also have a form in which it is embedded in the substrate 201.

In addition, although a conductor pattern formed by stacking a metal thin film having excellent electrical conductivity on the substrate 210 has been described as an example of the coil 210 according to the present exemplary embodiment, the present disclosure is not limited thereto, but may be variously applied. For example, a conducting wire wound in a vortex shape and then attached to the substrate 201 or embedded in the substrate 201 may be used as the coil 210.

The circuit unit 220 may include at least one electronic element 212, be mounted on the substrate 201, and be electrically connected to the coil 210. Here, the electronic element 212 may be a capacitor or may be a combination of various electronic elements if necessary.

The wireless power relay apparatus 200 as described above may improve power transmission efficiency for the portable terminal 300 even in the case in which the portable terminal 300 is located at a position at which it is difficult to smoothly receive the power from the wireless charging apparatus 100.

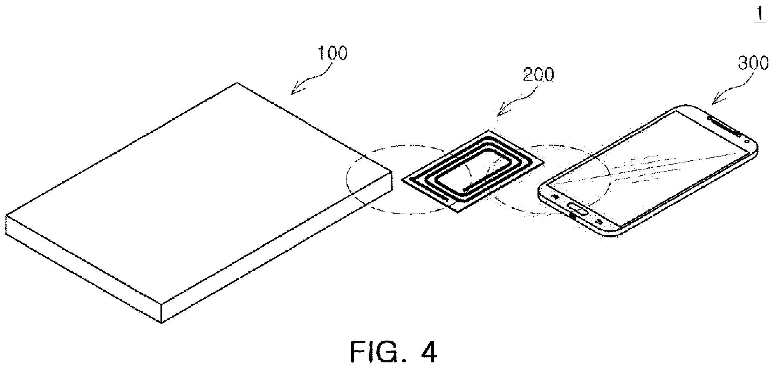

FIG. 4 is a perspective view schematically showing an example in which the wireless power relay apparatus according to an exemplary embodiment of the present disclosure is used. As shown in FIG. 4, in the case in which the portable terminal 300, which is the wireless power receiving apparatus is not located at an appropriate position on the wireless charging apparatus 100, which is the wireless power transmitting apparatus, but is disposed out of the appropriate position, it may be difficult that power transmission is substantially made.

However, in the case in which the wireless power relay apparatus 200 is disposed between the portable terminal 300 and the wireless charging apparatus 100 in this state, the wireless charging apparatus 100 may transmit the power to the wireless power relay apparatus 200. In addition, the wireless power relay apparatus 200 may again transfer the received power to the portable terminal 300. Therefore, the portable terminal 300 may receive the power that may not be normally received from the wireless charging apparatus 100.

That is, in the case of using the wireless power relay apparatus 200 according to the present exemplary embodiment, even though the portable terminal 300 is not located at an accurate position, charging efficiency may be significantly improved.

In addition, in the case in which the wireless power relay apparatus 200 is disposed between the portable terminal 300 and the wireless charging apparatus 100, as shown in FIG. 2, the power generated from the wireless charging apparatus 100 may be concentrated on the portable terminal as much as possible by the wireless power relay apparatus 200. Therefore, leakage of the power may be significantly decreased, such that wireless charging efficiency may be improved.

Meanwhile, although the portable terminal 300 has been described as an example of the wireless power receiving apparatus in the present exemplary embodiment, the wireless power receiving apparatus is not limited thereto, but may be various small electronic apparatuses such as a personal digital assistant (PDA), a portable MP3 player, a compact disk (DC) player, and the like.

In addition, although the case in which the wireless power relay apparatus 200 has a rectangular card shape has been described as an example in the present exemplary embodiment, the wireless power relay apparatus 200 is not limited to having the above-mentioned shape, but may have various shapes such as a circular shape, an oval shape, a polygonal shape, and the like.

Further, although the case in which the wireless power relay apparatus 200 is formed in the card shape has been described as an example in the present exemplary embodiment, the wireless power relay apparatus may also be formed in a three-dimensional shape, if necessary.

Meanwhile, the present disclosure is not limited to the above-mentioned exemplary embodiments, but may be variously modified.

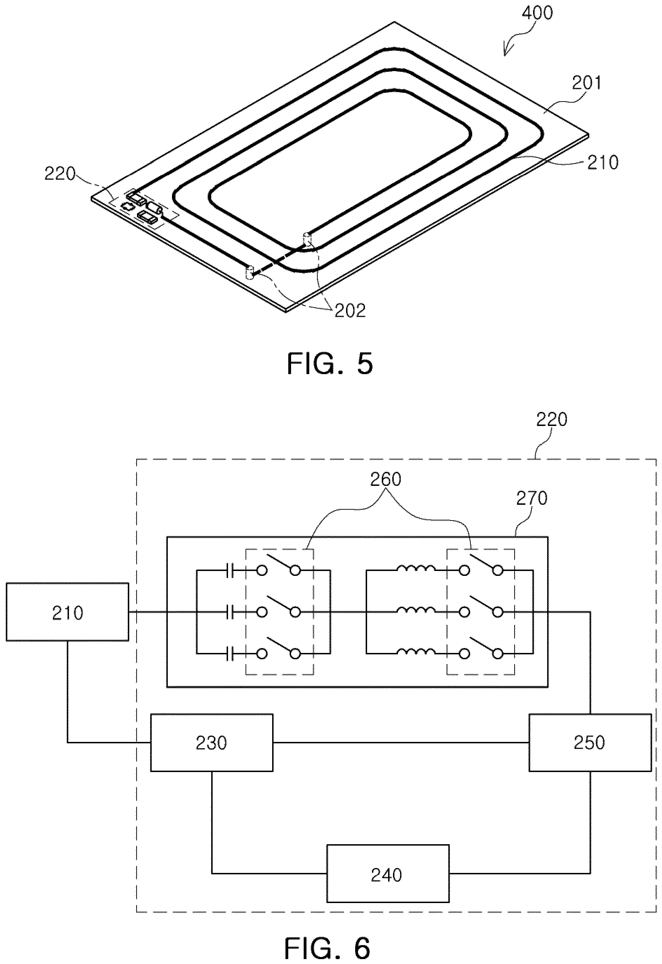

FIG. 5 is a perspective view schematically showing a wireless power relay apparatus according to another exemplary embodiment of the present disclosure; and FIG. 6 is a functional block diagram of the wireless power relay apparatus of FIG. 5.

Referring to FIGS. 5 and 6, in a wireless power relay apparatus 400 according to the present exemplary embodiment, a circuit unit 220 includes an impedance matching circuit.

When distances between or positions of the portable terminal, the wireless charging apparatus, and the wireless power relay apparatus are changed, a difference between impedances of the portable terminal, the wireless charging apparatus, and the wireless power relay apparatus may be generated, such that wireless power transmission efficiency may be deteriorated.

Therefore, the wireless power relay apparatus 400 according to the present exemplary embodiment includes the impedance matching circuit 220 in order to significantly decrease the difference between the impedances. Here, the impedance matching circuit includes a rectifying unit 230, a detecting unit 240, a controlling unit 250, and an impedance matching unit 270.

The rectifying unit 230 may include a rectifying circuit, and may rectify a transmission signal received through the coil 210 into direct current (DC) . To this end, the rectifying unit 230 may include a rectifying diode, a regulator, or the like.

Power obtained by the rectifying unit 230 is supplied to the controlling unit 250 and the detecting unit 240 and is used to drive the controlling unit 250 and the detecting unit 240. That is, the wireless power relay apparatus 400 according to the present exemplary embodiment obtains and uses power from the wireless power received by the coil 210. Therefore, the wireless power relay apparatus 400 according to the present exemplary embodiment does not need to include a separate driving source such as a battery.

The detecting unit 240 may detect a change in a waveform of a wireless power transmission signal. For example, the detecting unit 240 receives and monitors the transmission signal rectified by the rectifying unit 230. In addition, the detecting unit 240 transmits a detecting result to the controlling unit 250.

The controlling unit 250 controls the impedance matching unit 270 to have an optimal impedance value based on the detecting result of the detecting unit 240. This is performed by controlling a switching unit 260.

The impedance matching unit 270 has various impedance values preset through capacitors, and resistors.. In addition, the impedance matching unit 270 may be connected to the coil 210 at an optimal impedance value depending on switching of the switching unit 260 to complete impedance matching.

That is, the controlling unit 250 may switch the switching unit 260 based on information obtained through the detecting unit 240 to set an appropriate impedance value, thereby matching the impedance of the wireless power relay apparatus 400. Therefore, transmission efficiency may be optimized with respect to a current state.

In a process in which the wireless power relay apparatus 400 according to the present exemplary embodiment configured as described above receives the wireless power from the wireless charging apparatus 100 (See FIG. 2), the detecting unit 240 of the wireless power relay apparatus 400 may continuously monitor a waveform of the wireless power transmission signal.

When the difference between the impedances occurs, the waveform of the wireless power transmission signal received by the wireless power relay apparatus 400 may be changed. Therefore, the detecting unit 240 detects the change in the waveform of the wireless power transmission signal and transmits the detection result to the controlling unit.

Therefore, the controlling unit 250 may control the switching unit 260 based on an output of the detecting unit 240 to match an impedance to an optimal impedance value.

Meanwhile, although the case in which the impedance matching circuit is included in only the wireless power relay apparatus has been described as an example in the present exemplary embodiment, the present disclosure is not limited thereto. That is, in order to match impedances of the wireless power relay apparatus and the wireless power receiving apparatus to each other, the wireless power receiving apparatus may also include an impedance matching circuit. In addition, the wireless power transmitting apparatus may also include an impedance circuit, if necessary.

These impedance matching circuits may be implemented by a plurality of electronic elements including active element and passive elements. In addition, these electronic elements may be implemented in a form in which they are mounted on the substrate 201 as in the present exemplary embodiment or at least one thereof is embedded in the substrate 201. In this case, the substrate 201 of the wireless power relay apparatus 400 according to the present exemplary embodiment may be a circuit board 201 having wiring patterns formed on one surface or an inner portion thereof.

Meanwhile, the wireless power relay apparatus according to an exemplary embodiment of the present disclosure may be coupled integrally with a case of the portable terminal.

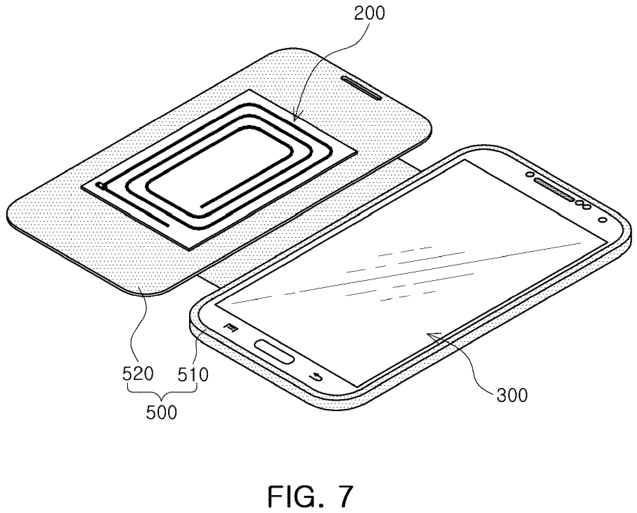

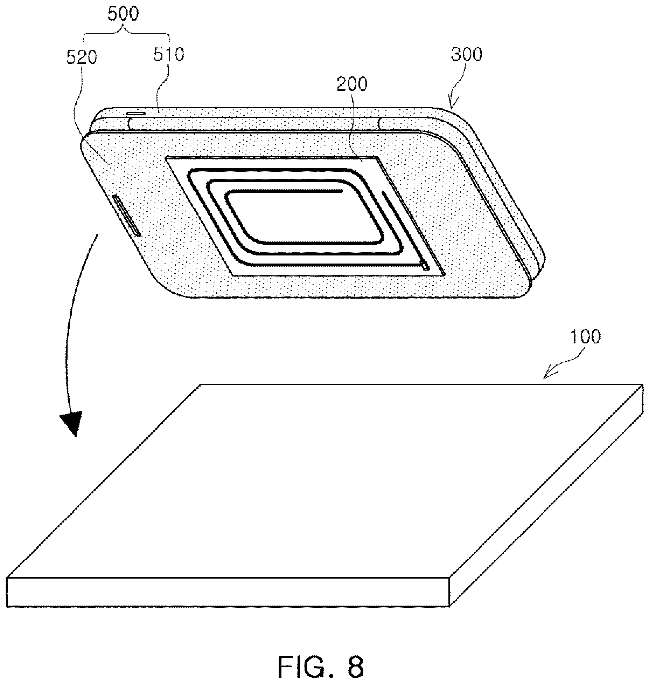

FIGS. 7 and 8 are views schematically showing a case and a portable terminal according to an exemplary embodiment of the present disclosure.

Referring to FIGS. 7 and 8, a flip case including a cover 520 or a diary case is used as a case 500 according to the present exemplary embodiment.

In detail, the case 500 according to the present exemplary embodiment includes a body case 510 having the portable terminal 300 coupled thereto, a cover 520 covering and protecting a front surface of the portable terminal 300, and the wireless power relay apparatus 200 attached to one surface of the cover 520.

When the case 500 according to the present exemplary embodiment is seated on the wireless charging apparatus 100 after the cover 520 thereof is folded toward a rear surface of the portable terminal 300 at the time of performing charging, as shown in FIG. 8, the wireless power relay apparatus 200 is positioned between the portable terminal 300 and the wireless relay apparatus 100. Therefore, wireless charging efficiency between the portable terminal 300 and the wireless charging apparatus may be naturally improved.

In other arrangements not forming part of the invention, the case 500 may be a protective case that does not have a cover. In this case, the wireless power relay apparatus 200 may be attached to a bottom surface of the case 500. Further, although not shown, the wireless power relay apparatus 200 may also be attached to a rear surface (opposite surface to the bottom surface) of the case 500.

However, the present disclosure is not necessarily limited to the above-mentioned configuration, but may be variously modified. For example, the wireless power relay apparatus may also be embedded in a bottom surface of the body case or the cover so as not to be exposed to the outside. In addition, various applications may be made. For example, an insertion pocket is formed in the case, and the wireless power relay apparatus is inserted into the insertion pocket, such that the wireless power relay apparatus may be easily coupled to and separated from the case.

As set forth above, in the case of using the wireless power relay apparatus according to an exemplary embodiment of the present disclosure, even though the portable terminal is not located at an accurate position, charging efficiency may be improved.

In addition, the wireless power relay apparatus according to an exemplary embodiment of the present disclosure includes an impedance matching circuit that does not require a driving source, whereby optimal charging efficiency may be provided according to several situations.

Further, the wireless power relay apparatus according to an exemplary embodiment of the present disclosure may be coupled to the case of the portable terminal to thereby be formed integrally with the case. Therefore, the wireless power relay apparatus may be always carried together with the portable terminal, such that a risk that the wireless power relay apparatus will be lost may be significantly decreased and the wireless power relay apparatus may be easily used when it is required.

While exemplary embodiments have been shown and described above, it will be apparent to those skilled in the art that modifications and variations could be made without departing from the scope of the present disclosure as defined by the appended claims.

For example, although the wireless power relay apparatus used for the portable terminal has been described the above-mentioned exemplary embodiments as an example, the wireless power relay apparatus according to the present disclosure is not limited thereto, but may be widely applied to all electronic apparatuses capable of being used by charging power therein and all power transmitting and receiving apparatuses capable of transmitting and receiving the power.

## Claims

1. A wireless power relay apparatus coupling case comprising:
a case (500) of an electronic apparatus; and
a wireless power relay apparatus (400) coupled to the case (500), and disposed between the electronic apparatus and a wireless charging apparatus (100) to transfer received power to the electronic apparatus at the time of performing charging,
wherein the wireless power relay apparatus (400) comprises:
a substrate (201);
a coil (210) formed on the substrate (201); **characterised in that** an impedance matching circuit (220) is electrically connected to the coil wherein the impedance matching circuit (220) includes:
an impedance matching unit (270) having various impedance values preset through capacitors and resistors;
a controlling unit (250) selecting an appropriate impedance value from the impedance matching unit (270) depending on a state of wireless power received by the coil (210) ;
a rectifying unit (230) rectifying the wireless power received by the coil (210) and supplying the rectified power to the controlling unit (250);
a detecting unit (240) sensing a current rectified by the rectifying unit (230) to detect a state of a wireless power transmission signal and transmit the detected state of the wireless power transmission signal to the controlling unit (250) ; and
a switching unit (260) selecting an impedance value of the impedance matching unit (270) depending on a control of the controlling unit (250),
wherein the case (500) includes a body case (510) coupled to the electronic apparatus and a cover (520) covering a front surface of the electronic apparatus,
the wireless power relay apparatus (400) is embedded in the case (500) and attached to one surface of the cover (520), and
the cover (520) is folded toward a rear surface of the electronic apparatus at the time of performing charging.

2. The wireless power relay apparatus coupling case of claim 1, wherein the electronic apparatus includes a portable terminal (300).

## Patentansprüche

1. Ein Verbindungsgehäuse einer drahtlosen Leistungsrelaisvorrichtung, umfassend:
ein Gehäuse (500) einer elektronischen Vorrichtung; und
eine drahtlose Leistungsrelaisvorrichtung (400), die mit dem Gehäuse (500) verbunden ist und zwischen der elektronischen Vorrichtung und einer drahtlosen Ladevorrichtung (100) angeordnet ist, um zum Zeitpunkt des Ladevorgangs empfangene Leistung an die elektronische Vorrichtung zu übertragen,
wobei die drahtlose Leistungsrelaisvorrichtung (400) Folgendes umfasst:
ein Substrat (201);
eine auf dem Substrat (201) gebildete Spule (210);
**dadurch gekennzeichnet, dass**
eine Impedanzanpassungsschaltung (220) elektrisch mit der Spule verbunden ist, wobei die Impedanzanpassungsschaltung (220) Folgendes beinhaltet:
eine Impedanzanpassungseinheit (270) mit unterschiedlichen, durch Kondensatoren und Widerstände voreingestellten Impedanzwerten;
eine Steuereinheit (250), die einen geeigneten Impedanzwert aus der Impedanzanpassungseinheit (270) in Abhängigkeit von einem Zustand der von der Spule (210) empfangenen drahtlosen Leistung auswählt;
eine Gleichrichtereinheit (230), die die von der Spule (210) empfangene drahtlose Leistung gleichrichtet und die gleichgerichtete Leistung an die Steuereinheit (250) liefert;
eine Erfassungseinheit (240), die einen von der Gleichrichtungseinheit (230) gleichgerichteten Strom erfasst, um einen Zustand eines drahtlosen Leistungsübertragungssignals zu erfassen und den erfassten Zustand des drahtlosen Leistungsübertragungssignals an die Steuereinheit (250) zu übertragen; und
eine Schalteinheit (260), die einen Impedanzwert der Impedanzanpassungseinheit (270) in Abhängigkeit von einer Steuerung der Steuereinheit (250) auswählt,
wobei das Gehäuse (500) ein Körpergehäuse (510) beinhaltet, das mit der elektronischen Vorrichtung gekoppelt ist, und eine Abdeckung (520), die eine Vorderfläche der elektronischen Vorrichtung bedeckt,
die drahtlose Leistungsrelaisvorrichtung (400) in das Gehäuse (500) eingebettet ist und an einer Oberfläche der Abdeckung (520) angebracht ist, und
die Abdeckung (520) zum Zeitpunkt des Ladevorgangs in Richtung einer hinteren Oberfläche der elektronischen Vorrichtung gefaltet ist.

2. Verbindungsgehäuse der drahtlosen Leistungsrelaisvorrichtung gemäß Anspruch 1, wobei die elektronische Vorrichtung ein tragbares Terminal (300) beinhaltet.

## Revendications

1. Boîtier de couplage d'appareil de relais de puissance sans fil comprenant:
un boîtier (500) d'un appareil électronique; et
un appareil de relais de puissance sans fil (400) couplé au boîtier (500), et disposé entre l'appareil électronique et un appareil de charge sans fil (100) pour transférer la puissance reçue à l'appareil électronique au moment d'effectuer la charge, dans lequel l'appareil de relais de puissance sans fil (400) comprend:
un substrat (201) ;
une bobine (210) formée sur le substrat (201); **caractérisé en ce que** un circuit d'adaptation d'impédance (220) connecté électriquement à la bobine, dans lequel le circuit d'adaptation d'impédance (220) comprend:
une unité d'adaptation d'impédance (270) ayant diverses valeurs d'impédance préréglées via des condensateurs et des résistances;
une unité de commande (250) sélectionnant une valeur d'impédance appropriée dans l'unité d'adaptation d'impédance (270) en fonction d'un état de puissance sans fil reçue par la bobine (210);
une unité de redressement (230) redressant la puissance sans fil reçue par la bobine (210) et fournissant la puissance redressée à l'unité de commande (250);
une unité de détection (240) détectant un courant redressé par l'unité de redressement (230) pour détecter un état d'un signal de transmission de puissance sans fil et transmettre l'état détecté du signal de transmission de puissance sans fil à l'unité de commande (250); et
une unité de commutation (260) sélectionnant une valeur d'impédance de l'unité d'adaptation d'impédance (270) en fonction d'une commande de l'unité de commande (250),
dans lequel le boîtier (500) comprend un boîtier de corps (510) couplé à l'appareil électronique et un couvercle (520) couvrant une surface avant de l'appareil électronique,
l'appareil de relais de puissance sans fil (400) est intégré dans le boîtier (500) et fixé à une surface du couvercle (520), et le couvercle (520) est plié vers une surface arrière de l'appareil électronique au moment d'effectuer la charge.

2. Boîtier de couplage d'appareil de relais de puissance sans fil selon la revendication 1, dans lequel l'appareil électronique comprend un terminal portable (300).
